## Europäisches Patentamt
## European Patent Office
## Office européen des brevets

(19)

(11) Numéro de publication: **0 170 571 B1**

(12) # FASCICULE DE BREVET EUROPEEN

(45) Date de publication du fascicule du brevet:
**18.10.89**

(51) Int. Cl.⁴: **G 11 C 11/40**

(21) Numéro de dépôt: **85401338.0**

(22) Date de dépôt: **02.07.85**

(54) Cellule mémoire statique CMOS.

(30) Priorité: **05.07.84 FR 8410674**

(43) Date de publication de la demande:
**05.02.86 Bulletin 86/6**

(45) Mention de la délivrance du brevet:
**18.10.89 Bulletin 89/42**

(84) Etats contractants désignés:
**CH DE GB IT LI NL**

(56) Documents cités:
**EP-A- 0 104 616**

(73) Titulaire: **COMMISSARIAT A L'ENERGIE ATOMIQUE,
31/33, rue de la Fédération, F-75015 Paris (FR)**

(72) Inventeur: **Jeuch, Pierre, 13, rue du Parc,
F-38170 Seyssins (FR)**

(74) Mandataire: **Mongrédien, André et al, c/o
BREVATOME 25, rue de Ponthieu, F-75008 Paris (FR)**

## Description

La présente invention a pour objet une cellule mémoire statique CMOS. Elle peut être utilisée dans le domaine de la microélectronique pour la réalisation de mémoires vives servant notamment à la mémorisation d'informations binaires.

Les mémoires statiques CMOS, (Metal Oxyde Semiconducteur Complémentaire), constituées uniquement de transistors MOS à canal N et de transistors MOS à canal P, présentent l'avantage de consommer très peu d'énergie électrique et de présenter une forte immunité aux parasites, notamment électriques. En revanche, elles présentent une densité d'intégration relativement faible.

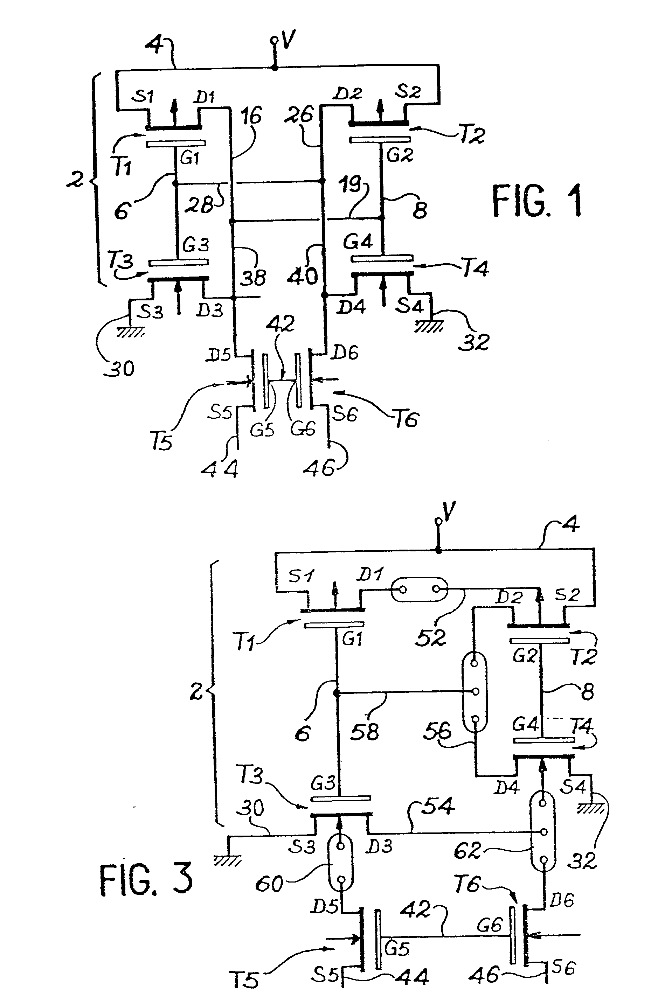

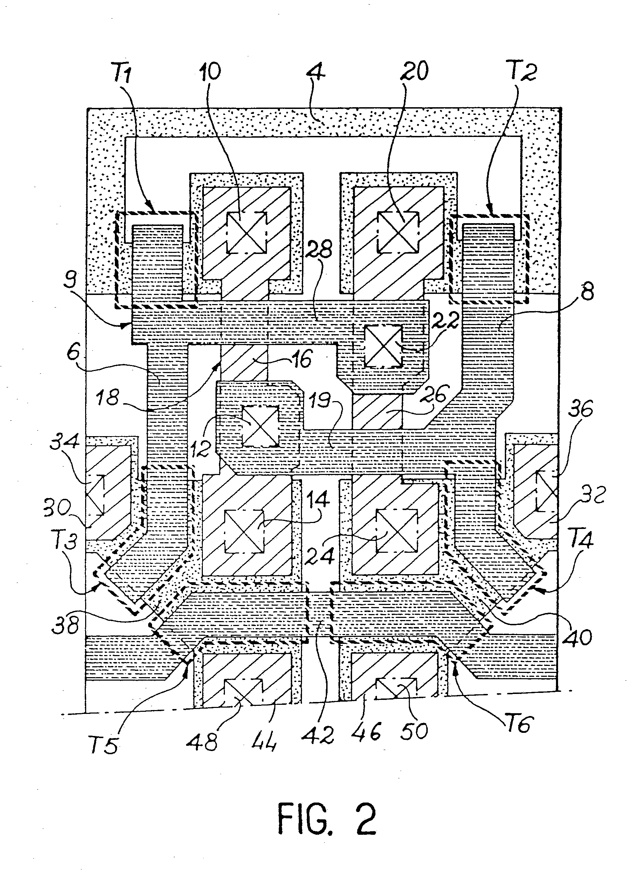

Cette faible densité d'intégration est notamment liée à la présence, dans chaque cellule mémoire, de plusieurs trous de contact électriques nécessaires pour la réalisation des connexions des différents transistors entre eux formant une cellule mémoire, ces trous de contact étant réalisés dans une couche isolante, notamment en oxyde de silicium, déposée sur l'ensemble du circuit, ainsi qu'aux gardes nécessaires pour le positionnement de ces trous de contact. Ceci est illustré par les figures 1 et 2 annexées sur lesquelles on a représenté, respectivement le schéma électrique d'une cellule mémoire CMOS conformément à l'art antérieur (cf. EP-A 104 616), et, en vue de dessus, l'organisation des différentes couches constituant cette cellule.

Cette cellule mémoire comprend un bistable ou une bascule 2 formé de deux transistors MOS $T_1$ et $T_2$ à canal P et de deux transistors MOS $T_3$ et $T_4$ à canal N, reliés électriquement entre eux.

Cette cellule mémoire comprend de plus deux transitors MOS $T_5$ et $T_6$ à canal N constituant les transistors d'attaque du bistable 2 de la cellule.

Comme représenté sur les figures 1 et 2, les sources notées $S_1$ et $S_2$ des transitors $T_1$ et $T_2$ sont connectées entre elles au moyen d'une ligne d'interconnexion 4, diffusée dans le substrat sur lequel est réalisée la cellule, et sont portées à un potentiel V positif délivré par une source d'alimentation électrique (non représentée). Par ailleurs, les grilles des transistors $T_1$ et $T_3$, notés $G_1$ et $G_3$ (figure 1), sont reliées électriquement entre elles; de même, les grilles $G_2$ et $G_4$ des transistors $T_2$ et $T_4$.

La connexion des grilles des transistors $T_1$ et $T_3$ est réalisée au moyen d'une ligne d'interconnexion 6 et la connexion des grilles des transistors $T_2$ et $T_4$ au moyen d'une ligne d'interconnexion 8, ces lignes 6 et 8 étant réalisées (figure 2) dans une couche conductrice gravée 9, généralement en silicium polycristallin, servant aussi à la réalisation des différentes grilles.

De plus, comme représenté sur la figure 1, le drain, noté $D_1$, du transistor $T_1$ est relié électriquement au drain $D_3$ du transistor $T_3$ ainsi qu'aux grilles $G_2$ et $G_4$ des transistors $T_2$ et $T_4$.

Ces connexions, comme représenté sur la figure 2, sont réalisées par l'intermédiaire de trois trous de contact électrique 10, 12 et 14, réalisés dans une couche de matériau isolant, notamment en oxyde de silicium (non représentée); une ligne d'interconnexion 16, réalisée dans une couche conductrice 18 notamment en aluminium, assure la connexion entre le drain, $D_1$ du transistor $T_1$ et le drain $D_3$ du transistor $T_3$, cette ligne 16 étant respectivement au contact du drain $D_1$ et du drain $D_3$ grâce aux trous de contact électrique 10 et 14, et une ligne d'interconnexion 19 réalisée dans la couche conductrice 9 gravée, assure la connexion des zones actives $D_1$ et $D_3$ avec les grilles des transistors $T_2$ et $T_4$, cette ligne 19 étant au contact de la ligne 16 grâce au trou de contact 12 pratiqué dans ladite ligne 16.

De même, comme représenté sur la figure 1, le drain du transistor $T_2$ noté $D_2$, est relié électriquement au drain $D_4$ du transistor $T_4$ ainsi qu'aux grilles $G_1$ et $G_3$ des transistors $T_1$ et $T_3$.

Comme représenté sur la figure 2, ces connexions sont réalisées par l'intermédiaire de trois trous de contact électrique 20, 22 et 24, réalisés dans la couche de matériau isolant; une ligne d'interconnexion 26, réalisée dans la couche conductrice 18, assure la connexion entre le drain $D_2$ du transistor $T_2$ et le drain $D_4$ du transistor $T_4$, cette ligne 26 étant respectivement au contact du drain $D_2$ et du drain $D_4$ grâce aux trous de contact électriques 20 et 24, et une ligne d'interconnexion 28, réalisée dans la couche conductrice 9, assure la connexion entre les zones actives $D_2$ et $D_4$ et les grilles des transistors $T_1$ et $T_3$, cette ligne 28 étant au contact de la ligne 26 grâce au trou de contact 22 pratiqué dans ladite ligne 26.

Par ailleurs, les sources $S_3$ et $S_4$ des transistors $T_3$ et $T_4$ sont portées au potentiel de la masse (figure 1). Ces connexions sont assurées au moyen des lignes d'interconnexion 30 et 32, réalisés dans la couche conductrice 18, prenant contact respectivement avec les sources $S_3$ et $S_4$ des transistors $T_3$ et $T_4$ par l'intermédiaire de trous de contact électrique 34 et 36 (figure 2), réalisés dans la couche isolante.

Comme représenté sur la figure 1, l'attaque du bistable 2 de la cellule mémoire est réalisée par le transistor $T_5$ rellié par son drain $D_5$ au drain $D_3$ du transistor $T_3$, au drain $D_1$ du transistor $T_1$ et aux grilles $G_2$ et $G_4$ des transistors $T_2$ et $T_4$ ou par le transistor $T_6$ dont le drain $D_6$ est relié au drain $D_4$ du transistor $T_4$, au drain $D_2$ du transistor $T_2$ ainsi qu'aux grilles $G_1$ et $G_3$ des transistors $T_1$ et $T_3$.

La connexion entre le drain $D_5$ du transistor $T_5$ et le drain $D_3$ du transistor $T_3$ est, comme représenté sur la figure 2, aussurée par une ligne d'interconnexion 38, diffusée dans le substrat, et la connexion entre le drain $D_6$ du transistor $T_6$ et le drain $D_4$ du transistor $T_4$ est assurée par une ligne d'interconnexion 40, diffusée dans le substrat. Les autres connexions des drains $D_5$ et $D_6$ des transistors $T_5$ et $T_6$ sont réalisées, comme précédemment, par l'intermédiaire des trous de contact électrique respectivement 10, 12, 14 et 20, 22, 24 et des lignes d'interconnexion respectivement 16, 19, 8 et 26, 28, 6.

Les signaux électriques servant à la sélection de la cellule mémoire sont envoyés sur les grilles

$G_5$ et $G_6$ des transistors $T_5$ et $T_6$, reliées électriquement entre elles par la ligne d'interconnexion 42, réalisée dans la couche conductrice 9, et les informations à mémoriser dans cette cellule mémoire sélectionnée ou à sortir de ladite cellule sont transmises par les sources $S_5$ et $S_6$ de ces transistors $T_5$ et $T_6$. Ces informations sont véhiculées par des lignes 44 et 46 réalisées dans la couche conductrice 18, prenant contact respectivement sur les sources $S_5$ et $S_6$ des transistors $T_5$ et $T_6$, par l'intermédiaire de trous de contacts électriques 48 et 50 (figure 2) réalisés dans la couche d'isolant et d'une deuxième couche conductrice notamment en aluminium, non représentée.

La présence des six trous de contact électrique 10, 12, 14, 20, 22 et 24, ces trous étant nécessaires pour réaliser les connexions internes de la cellule mémoire CMOS, compte tenu de l'organisation des différentes couches constituant cette cellule et en particulier du croisement des lignes d'interconnexion réalisées dans les couches conductrices 9 et 18, limite la densité d'intégration de la cellule mémoire.

La présente invention a justement pour but une celule mémoire statique CMOS présentant une organisation différente de celle des cellules mémoire de l'art antérieur, permettant de supprimer tous les trous de contact électriques utilisés pour les connexions internes des cellules mémoire de l'art antérieur et donc d'augmenter la densité d'intégration des cellules mémoire.

De façon plus précise, l'invention a pour objet une cellule mémoire statique CMOS comprenant de façon connue un bistable, formé de deux transistors MOS à canal P, dits premier et second transistors, et de deux transistors MOS à canal N, dits troisième et quatrième transistors, un cinquième et un sixième transistors MOS à canal N servant à commander le bistable; ces transistors du bistable sont reliés électriquement entre eux de façon que:

– les grilles des premier et troisième transistors soient reliées entre elles,
– les grilles des deuxième et quatrième transistors soient reliées entre elles,
– les sources des premier et deuxième transistors soient reliées entre elles et à une source d'alimentation électrique,
– les sources des troisième et quatrième transistors soient reliées à la masse,
– le drain du deuxième transistor soit relié aux grilles des premier et troisième transistors, et au drain du quatrième transistor.

La cellule se caractérise en ce que les lignes d'interconnexion servant à connecter les différents transistors entre eux ne se croisent pas, et en ce que:
– le drain du premier transistor soit relié uniquement à la grille du deuxième transistor par une ligne d'interconnexion qui est au contact direct du drain du premier transistor et d'un prolongement de la grille du deuxième transistor, et
– le drain du troisième transistor soit relié, dans le bistable, uniquement à la grille au quatrième transistor, à l'aide d'une ligne d'interconnexion qui est au contact direct au drain du troisième transistor et d'un prolongement de la grille du quatrième transistor.

Le non croisement des lignes d'interconnexion des différents transistors constituant la cellule permet de supprimer tous les trous de contact électrique internes de la cellule et d'augmenter ainsi la densité d'intégration.

Selon un mode préféré de réalisation de la cellule mémoire de l'invention, les drains des cinquième et sixième transistor sont reliés respectivement et directement à la grille du troisième transistor et à la grille du quatrième transistor, les grilles de ces cinquième et sixième transistors, reliées entre elles, servant à véhicules les signaux de sélection de la cellule et les sources de ces cinquième et sixième transistors servant à véhiculer les informations à mémoriser ou à lire.

Les caractéristiques et avantages de l'invention ressortiront mieux de la description qui va suivre, donnée à titre illustratif et non limitatif, en référence aux figures annexées, dans lesquelles:

– la figure 1, déjà décrite, représente le schéma électrique d'une cellule mémoire statique CMOS de l'art antérieur,
– la figure 2, déjà décrite, représente, en vue de dessus, l'organisation des différentes couches constituant la cellule de la figure 1.
– la figure 3 représente le schéma électrique d'une cellule mémoire statique CMOS conformément à l'invention,
– la figure 4 représente, en vue de dessus, l'organisation des différentes couches constituant la cellule de la figure 3, et
– les figures 5 à 8 illustrent, en coupe longitudinale, les différentes étapes d'un procédé de fabrication d'une cellule mémoire selon l'invention.

La cellule selon l'invention comprend, comme précédemment, un bistable ou une bascule 2 formé de deux transistors MOS $T_1$ et $T_2$ à canal P et de deux transistors MOS $T_3$ et $T_4$ canal N qui constituent les transistors de commande de la cellule, ainsi que de deux transistors d'attaque du bistable $T_5$ et $T_6$ qui sont des transistors MOS à canal N.

Comme pour les cellules de l'art antérieur, les sources $S_1$ et $S_2$ des transistors $T_1$ et $T_2$ sont reliées électriquement entre eux, au moyen de la ligne d'interconnexion 4 diffusée dans le substrat dans lequel est réalisée le cellule, et portées à un potentiel V positif délivré par une source d'alimentation électrique. Par ailleurs, les grilles $G_1$ et $G_3$ des transistors $T_1$ et $T_3$ sont reliées électriquement entre elles au moyen de la ligne d'interconnexion 6 et les grilles $G_2$ et $G_4$ des transistors $T_2$ et $T_4$ sont reliées aussi entre elles au moyen de la ligne d'interconnexion 8, les lignes 6 et 8 étant réalisées, comme précédemment dans la couche conductrice 9 gravée notamment en silicium polycristallin, servant à la réalisation des grilles des transistors de la cellule de l'invention.

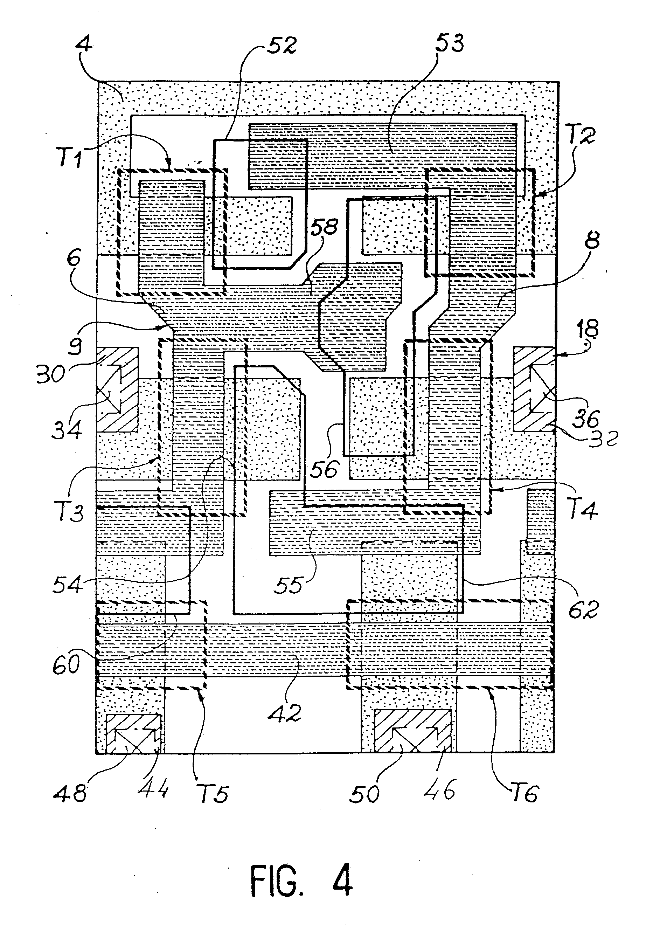

De plus, comme dans l'art antérieur, les sources $S_3$ et $S_4$ des transistors $T_3$ et $T_4$ sont portées au potentiel de la masse (figure 3); ces connexions sont assurées, au moyen des lignes d'interconnexion 30 et 32, réalisées dans la couche conductrice 18, notamment en aluminium, prenant contact respectivement avec lesdites sources $S_3$ et $S_4$ par l'intermédiaire des trous de contact électrique 34 et 36 (figure 4), réalisées dans la couche isolante notamment en oxyde de silicium (non représentée).

Enfin, comme dans l'art antérieur, les grilles $G_5$ et $G_6$ des transistors $T_5$ et $T_6$ par lesquelles arrivent les signaux de sélection de la cellule à mémoire, sont reliées électriquement entre elles (figure 3) au moyen de la ligne d'interconnexion 42, réalisée dans la couche conductrice 9 et les sources $S_5$ et $S_6$ de ces transistors $T_5$ et $T_6$ respectivement aus lignes d'interconnexion 44 et 46, servant à véhiculer les informations à mémoriser ou à extraire de la cellule à mémoire, ces lignes 44 et 46, réalisées dans la couche conductrice 18 prenant contact respectivement sur les sources $S_5$ et $S_6$ par l'intermédiaire des trous de contact électrique 48 et 50 (figure 4).

Conformément à l'invention, le drain $D_1$ du transistor $T_1$ est relié uniquement à la grille $G_2$ du transistor $T_2$ (figure 3) par la ligne d'interconnexion 52, sans isolement, prenant contact directement sur le drain $D_1$ et sur un prolongement 53 de la grille $G_2$ réalisé dans la couche conductrice 9 (figure 4). De même, le drain $D_3$ du transistor $T_3$ est relié, dans le bistable 2, uniquement à la grille du transistor $T_4$ (figure 3) au moyen d'une ligne d'interconnexion 54, sans isolement, directement au contact du drain $D_3$ et d'un prolongement 55 de la grille $G_4$, réalisé dans la couche 9 (figure 4).

Par ailleurs, le drain $D_2$ du transistor $T_2$ est relié au drain $D_4$ du transistor $T_4$ ainsi qu'aux grilles $G_1$ et $G_3$ des transistors $T_1$ et $T_3$ (figure 3). Ces connexions sont assurées au moyen d'une ligne d'interconnexion 56, sans isolement, directement au contact du drain $D_2$ et du drain $D_4$ et d'un prolongement 58 de la ligne d'interconnexion 6 reliant les grilles des transistors $T_1$ et $T_3$ (figure 4).

De plus, selon l'invention, l'attaque du bistable ou de la bascule 2 par les transistors $T_5$ et $T_6$ se fait d'une part par le drain $D_5$ du transistor $T_5$, relié uniquement à la grille $G_3$ du transistor $T_3$ (figure 3) au moyen de la ligne d'interconnexion 60, sans isolement, prenant directement contact sur le drain $D_5$ et la grille $G_3$ des transistors correspondants, et par le drain $D_6$ du transistor $T_6$, relié à la grille $G_4$ du transistor $T_4$ au moyen de la ligne d'interconnexion 62, sans isolement, prenant directement contact sur le drain $D_6$ et la grille $G_4$ des transistors correspondants (figure 4).

Les lignes d'interconnexion sans isolement 52, 54, 56, 60 et 62 sont réalisées dans une même couche conductrice, réalisée notamment en un alliage de titane et de tungstène. Leur procédé de fabrication sera décrit ultérieurement.

Comme le montrent les figures 3 et 4, les différentes connexions internes de la cellule mémoire de l'invention ne se croisent nullement. En particulier, les lignes d'interconnexion sans isolement ne croisent nullement les lignes d'interconnexion diffusées dans le substrat ni les lignes d'interconnexion réalisées dans la couche conductrice 9 dans laquelle sont réalisées les grilles.

L'organisation de la cellule mémoire statique, conformément à l'invention, permet, du fait de la réalisation des connexions internes de celle-ci sans utiliser de couche isolante, de supprimer tous les trous de contact électrique normalement utilisés pour la connexion des transistors de la cellule de l'art antérieur.

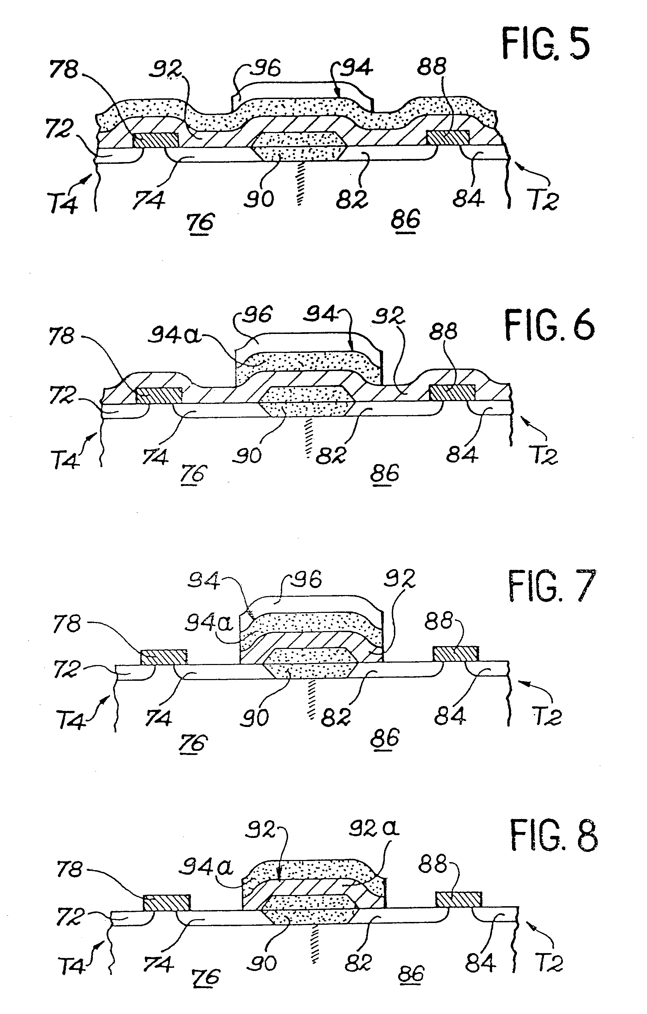

L'un des procédés permettant de relier électriquement entre eux les transistors de la cellule mémoire, sans réalisation de trous de contact électriques, réalisés dans une couche de matériau isolant, et permettant en particulier de réaliser les lignes d'interconnexion 52, 54, 56, 60 et 62 a été décrit dans la demande de brevet français no 8 404 204 déposée le 19 mars 1984 au nom du demandeur. Ce procédé va être décrit en référence aux figures 5 à 8 illustrant, en coupe longitudinale, les différentes étapes de ce procédé.

Afin de simplifier la description, celle-ci sera faite pour permettre la connexion du drain $D_2$ du transistor $T_2$ au drain $D_4$ du transistor $T_4$, au moyen de la ligne 56, mais bien entendu, ce procédé s'applique à toutes les connexions sans isolement, c'est-à-dire sans trou de contact électrique, de la cellule mémoire de l'invention.

Sur les figures 5 à 8, les références 72 et 74 correspondent respectivement à la source et au drain du transistor $T_4$ à canal N, réalisés dans un substrat 76 en silicium de type P, et la référence 78 correspond à la grille de ce transistor, réalisée notamment en silicium polycristallin.

De même, les références 82 et 84 représentent respectivement le drain et la source du transistor $T_2$ à canal P, réalisés par exemple dans un substrat 86 en silicium de type N, et la référence 88 représente la grille de ce transistor $T_2$, réalisée notamment en silicium polycristallin.

Par ailleurs, la référence 90 représente l'oxyde de champ séparant l'un de l'autre les transistors $T_2$ et $T_4$.

Selon ce procédé, l'interconnexion du drain 74 du transistor $T_4$ et du drain 82 du transistor $T_2$ est réalisée en déposant directement sur l'ensemble du circuit intégré, après réalisation de l'oxyde de champ, des grilles, des drains et des sources de ces transistors, une couche 92 du matériau conducteur par exemple en un alliage de titane et de tungstène, comme représenté sur la figure 5, puis en gravant cette couche 92 afin de réaliser la connexion désirée référencée 92a (figure 8).

La gravure de cette couche 92 peut être réalisée en déposant tout d'abord sur cette couche 92 une couche 94 d'un autre matériau, réalisée notamment en aluminium. On réalise ensuite, comme représenté sur la figure 6, un masque 96 de résine représentant l'image de la connexion 92a à réaliser. Puis, on élimine la partie de la couche 94 non recouverte par le masque 96, par exemple par un procédé de gravure anisotrope.

Ensuite, comme représenté sur la figure 7, on élimine la partie de la couche 92 non recouverte du restant 94a de la couche 94 par exemple par un procédé de gravure anisotrope, le restant 94a de la couche 94 servant de masque à cette gravure.

Enfin, comme représenté sur la figure 8, on élimine le masque de résine 96.

La couche 92, notamment en alliage de titane et de tungstène, ainsi gravée permet de connecter le drain 74 du transistor $T_4$ à canal N et le drain 82 du transistor $T_2$ du canal P.

Outre son rôle de masque pour la gravure de la couche 92, l'emploi de la couche 94 notamment en aluminium, permet d'éviter, lors des opérations ultérieures, l'oxydation de la couche en alliage de titane et de tungstène.

Ce procédé décrit pour connecter le drain du transistor $T_2$ au drain du transistor $T_4$ est bien entendu applicable pour réaliser toutes les connexions internes de la cellule mémoire conformément à l'invention, sans isolement, et notamment pour réaliser la connexion 52 entre le drain du transistor $T_1$ et la grille du transistor $T_2$, la connexion 56 du drain du transistor $T_2$, du drain du transistor $T_4$ et des grilles du transistor $T_1$ et $T_3$, la connexion 54 et 62 du drain du transistor $T_3$ à la grille du transistor $T_4$ et au drain du transistor $T_6$ ainsi que la connexion 60 entre le drain du transistor $T_5$ et la grille du transistor $T_3$.

Le procédé de connexion décrit ci-dessus perment, du fait de la suppression des contacts électriques à l'intérieur de la cellule mémoire de l'invention d'augmenter, par rapport aux cellules de l'art antérieur, de 27% la densité d'intégration.

Il est possible d'augmenter encore la densité d'intégration de la cellule mémoire en utilisant un procédé permettant d'obtenir un autoalignement ou autopositionnement des lignes d'interconnexion réalisées sans isolement, sur les zones actives et/ou les grilles à connecter entre elles, le procédé décrit précédemment n'étant pas un procédé autoaligné.

Comme procédé autoaligne ou autopositionné, on peut notamment utiliser celui décrit dans la demande de brevet français no 8 405 052 du 30 mars 1984 déposée au nom de demandeur.

Par ailleurs, contrairement aux cellules de l'art anérieur, il est encore possible d'augmenter la densité d'intégration en diminuant la distance séparant les zones actives des différents transistors à connecter de la cellule, grâce à l'absence des trous de contact électriques dans ladite cellule; ceci peut être réalisé en utilisant un procédé d'isolation entre les différents transistors de la cellule par tranchée d'isolement tel que celui décrit dans l'article IEDM-82 publié par IEEE de 1982 pages 237 à 240, intitulé «Depp Trench Isolated CMOS Devices», de R. D. Rung, H. Momose et Y. Nagakubo, au lieu d'utiliser un oxyde de champ localisé.

## Revendications

1. Cellule mémoire statique CMOS comprenant un bistable (2) formé de deux transistors MOS ($T_1$, $T_2$) à canal P, dits premier et second transistors, et de deux transistors MOS ($T_3$, $T_4$) à canal N, dits troisième et quatrième transistors, un cinquième ($T_5$) et un sixième ($T_6$) transistors MOS à canal N servant à commander le bistable (2) ces transistors ($T_1$, $T_2$, $T_3$, $T_4$) du bistable (2) sont reliés électriquement entre eux de façon que:

- les grilles ($G_1$, $G_3$) des premier ($T_1$) et troisième ($T_3$) transistors soient reliées entre elles,
- les grilles ($G_2$, $G_4$) des deuxième et quatrième ($T_2$, $T_4$) transistors soient reliées entre elles,
- les sources ($S_1$, $S_2$) des premier ($T_1$) et deuxième ($T_2$) transistors soient reliées entre elles et à une source d'alimentation électrique,
- les sources ($S_3$, $S_4$) des troisième ($T_3$) et quatrième ($T_4$) transistors soient reliées à la masse,
- le drain ($D_2$) du deuxième transistor ($T_2$) soit relié aux grilles ($G_1$, $G_3$) des premier ($T_1$) et troisième ($T_3$) transistors, et au drain ($D_4$) du quatrième transistor ($T_4$), caractériseé en ce que les lignes d'interconnexion (4, 6, 8, 42, 52, 54, 56, 58, 60, 62) servant à connecter les différents transistors ne se croisent pas et en ce que:

- le drain ($D_1$) du premier transistor ($T_1$) soit relié uniquement à la grille ($G_2$) du deuxième transistor ($T_2$) par une ligne d'interconnexion (52) qui est au contact direct du drain du premier transistor et d'un prolongement (53) de la grille du deuxième transistor, et
- le drain ($D_3$) du troisième transistor ($T_3$) soit relié, dans le bistable, uniquement à la grille ($G_4$) du quatrième transistor ($T_4$), à l'aide d'une ligne d'interconnexion (54) qui est au contact direct du drain du troisième transistor et d'un prolongement (55) de la grille du quatrième transistor.

2. Cellule mémoire selon la revendication 1, caractérisée en ce que les drains ($D_5$, $D_6$) des cinquième ($T_5$) et sixième ($T_6$) transistors son reliés respectivement et directement à la grille ($G_3$) du troisième transistor ($T_3$) et à la grille ($G_4$) du quatrième transistor ($T_4$), les grilles ($G_5$, $G_6$) de ces cinquième ($T_5$) et sixième ($T_6$) transistors, reliées entre elles, servant à véhiculer les signaux de sélection de la cellule et les sources ($S_5$, $S_6$) de ces cinquième ($T_5$) et sixième ($T_6$) transistors servant à véhiculer les informations à mémoriser ou à lire.

3. Cellule mémoire selon la revendication 1 ou 2, caractérisée en ce que les drains ($D_2$, $D_4$), des seonds ($T_2$) et quatrième ($T_4$) transistors sont reliés aux grilles ($G_1$, $G_3$) des premier ($T_1$) et troisième ($T_3$) transistors par une ligne d'interconnexion (56) qui est au contact direct des drans ($D_2$, $D_4$) des second et quatrième transistors et d'un prolongement (58) de la ligne d'interconnexion (6) des grilles ($G_1$, $G_3$) du premier et troisième transistors.

4. Cellule mémoire selon l'une quelconque des revendications 1 à 3, caractérisé en ce que le drain ($D_5$) du cinquième transistor ($T_5$) est relié à la grille ($G_3$) du troisième transistor ($T_3$) par une ligne d'interconnexion (60) qui est au contact direct du drain ($D_5$) du cinquième transistor et de la grille ($G_3$) du troisième transistor.

5. Cellule mémoire selon l'une quelconque des revendications 1 à 4, caractérisée en ce que le drain ($D_6$) du sixième transistor ($T_6$) est relié à la grille ($G_4$) du quatrième transistor ($T_4$) par une ligne d'interconnexion (62) qui est au contact direct du drain ($D_6$) du sixième transistor et de la grille ($G_4$) du quatrième transistor.

**Patentansprüche**

1. Statische CMOS-Speicherzelle, enthaltend eine bistabile Kippstufe (2) aus zwei P-Kanal-MOS-Transistoren ($T_1$, $T_2$), genannt erste und zweite Transistoren, und aus zwei N-Kanal-MOS-Transistoren ($T_3$, $T_4$) genannt dritte und vierte Transistoren, einen fünften ($T_5$) und einen sechsten ($T_6$) N-Kanal-MOS-Transistor zur Ansteuerung der bistabilen Kippstufe (2), wobei die Transistoren ($T_1$, $T_2$, $T_3$, $T_4$) der bistabilen Kippstufe (2) elektrisch derart miteinander verbunden sind, dass:

die Gates ($G_1$, $G_3$) des ersten ($T_1$) und des dritten ($T_3$) Transistors miteinander verbunden sind,

die Gates ($G_2$, $G_4$) des zweiten und des vierten Transistors ($T_2$, $T_4$) miteinander verbunden sind,

die Sources ($S_1$, $S_2$) der ersten und zweiten Transistoren ($T_1$, $T_2$) miteinander und mit einer elektrischen Stromversorgungsquelle verbunden sind,

die Sources ($S_3$, $S_4$) der dritten und vierten Transistoren ($T_3$, $T_4$) mit Masse verbunden sind, dass Drain ($D_2$) des zweiten Transistors ($T_2$) mit den Gates ($G_1$, $G_3$) der ersten und dritten Transistoren ($T_1$, $T_3$) und mit dem Drain ($D_4$) des vierten Transistors ($T_4$) verbunden ist, dadurch gekennzeichnet, dass die Verbindungsleitungen (4, 6, 8, 42, 52, 54, 56, 58, 60, 62), die der Verbindung der verschiedenen Transistoren untereinander dienen, sich nicht kreuzen, und dass das Drain ($D_1$) des ersten Transistors ($T_1$) allein mit dem Gate ($G_2$) des zweiten Transistors ($T_2$) über eine Verbindungsleitung (52) verbunden ist, die direkt mit dem Drain des ersten Transistors und mit einer Verlängerung (53) des Gate des zweiten Transistors verbunden ist, und dass das Drain ($D_3$) des dritten Transistors ($T_3$) in der bistabilen Kippstufe einzig mit dem Gate ($G_4$) des vierten Transistors ($T_4$) mittels einer Verbindungsleitung (54) verbunden ist, die in direkter Berührung mit dem Drain des dritten Transistors und mit einer Verlängerung (55) des Gate des vierten Transistors ist.

2. Speicherzelle nach Anspruch 1, dadurch gekennzeichnet, dass die Drains ($D_5$, $D_6$) der fünften und sechsten Transistoren ($T_5$, $T_6$) direkt mit dem Gate ($G_3$) des dritten Transistors ($T_3$) bzw. dem Gate ($G_4$) des vierten Transistors ($T_4$) verbunden sind, wobei die Gates ($G_5$, $G_6$) dieser fünften und sechsten Transistoren ($T_5$, $T_6$), die untereinander verbunden sind, dazu dienen, die Wählsignale der Zelle zu übertragen und die Sources ($S_5$, $S_6$) dieser fünften und sechsten Transistoren ($T_5$, $T_6$) dazu dienen, die einzuspeichernden oder auszulesenden Informationen zu übertragen.

3. Speicherzelle nach Anspruch 1 oder 2, dadurch gekennzeichnet, dass die Drains ($D_2$, $D_4$) der zweiten und vierten Transistoren ($T_2$, $T_4$) mit den Gates ($G_1$, $G_3$) der ersten und dritten Transistoren ($T_1$, $T_3$) über eine Verbindungsleitung (56) verbunden sind, die in direkter Berührung mit den Drains ($D_2$, $D_4$) der zweiten und vierten Transistoren und mit einer Verlängerung (58) der Verbindungsleitung (6) der Gates ($G_1$, $G_3$) der ersten und dritten Transistoren sind.

4. Speicherzelle nach einem der Ansprüche 1 bis 3, dadurch gekennzeichnet, dass das Drain ($D_5$) des fünften Transistors ($T_5$) mit dem Gate ($G_3$) des dritten Transistors ($T_3$) über eine Verbindungsleitung (60) verbunden ist, die in direkter Berührung mit dem Drain ($D_5$) des fünften Transistors und mit dem Gate ($G_3$) des dritten Transistors ist.

5. Speicherzelle nach einem der Ansprüche 1 bis 3, dadurch gekennzeichnet, dass das Drain ($D_6$) des sechsten Transistors ($T_6$) mit dem Gate ($G_4$) des vierten Transistors ($T_4$) über eine Verbindungsleitung (62) verbunden ist, die in direkter Berührung mit dem Drain ($D_6$) des sechsten Transistors und mit dem Gate ($G_4$) des vierten Transistors ist.

**Claims**

1. CMOS static storage cell comprising a bistable element (2) formed from two channel P MOS transistors ($T_1$, $T_2$) called first and second transistors, and two channel N MOS transistors ($T_3$, $T_4$), called third and fourth transistors, a fifth ($T_5$) and a sixth ($T_6$) channel N MOS transistors being used for controlling the bistable element (2), said transistors ($T_1$, $T_2$, $T_3$, $T_4$) of the bistable element (2) being electrically interconnected, in such a way that the gates ($G_1$, $G_3$) of the first ($T_1$) and third ($T_3$) are interconnected, the gates ($G_2$, $G_4$) of the second ($T_2$) and fourth ($T_4$) transistors are interconnected, the sources ($S_1$, $S_2$) of the first ($T_1$) and second ($T_2$) transistor are interconnected and connected to a power supply source and the sources ($S_3$, $S_4$) of the third ($T_3$) and fourth ($T_4$) transistors are connected to earth, the drain ($D_2$) of the second transistor ($T_2$) is connected to the gates ($G_1$, $G_3$) of the first ($T_1$) and third ($T_3$) transistors and to the drain ($D_4$) of the fourth transistor ($T_4$), the cell being characterized in that the interconnecting lines (4, 6, 8, 42, 52, 54, 56, 58, 60, 62) for connecting the different transistors to one another do not intersect, in that the drain ($D_1$) of the first transistor ($T_1$) is solely connected to the gate ($G_2$) of the second transistor ($T_2$) by an interconnection line (52) in direct contact with the drain of the first transistor and an extension (53) of the gate of the second transistor and the drain ($D_3$) of the third transistor ($T_3$) is connected, in the bistable element, solely to the gate ($G_4$) of the fourth transistor ($T_4$), with the aid of an interconnection line (54) in direct contact with the drain of the third transistor and an extension (55) of the gate of the fourth transistor.

2. Storage cell according to claim 1, characterized in that the drains ($D_5$, $D_6$) of the fifth ($T_5$) and

sixth (T_6) transistor are respectively connected to the gate (G_3) of the third transistor (T_3) and to the gate (G_4) of the fourth transistor (T_4), the gates of the fifth (T_5) and sixth (T_6) transistors, which are interconnected being used for carrying the cell selection signals and the sources (S_5, S_6) of these fifth (T_5) and sixth (T_6) transistors are used for carrying the information to be stored or read.

3. Storage cell according to claim 1 or 2, characterized in that the drains (D_2, D_4) of the second (T_2) are connected to the gates (G_1, G_3) of the first (T_1) and third (T_3) transistors by an interconnection line (56), which is direct contact with the drains (D_2, D_4) of the second and fourth transistors and an extension (58) of the interconnection line (6) of the gates (G_1, G_3) of the first and third transistors.

4. Storage cell according to any one of the claims 1 to 3, characterized in that the drain (D_5) of the fifth transistor (T_5) is connected to the gate (G_3) of the third transistor (T_3) by an interconnection line (60), which is in direct contact with the drain (D_5) of the fifth transistor and the gate (G_3) of the third transistor.

5. Storage cell according to any one of the claims 1 to 3, characterized in that the drain (D_6) of the sixth transistor (T_6) is connected to the gate (G_4) of the fourth transistor (T_4) by an interconnection line (62), which is in direct contact with the drain (D_6) of the sixth transistor and the gate (G_4) of the fourth transistor.

FIG. 1

FIG. 3

FIG. 2

FIG. 4

FIG. 5

FIG. 6

FIG. 7

FIG. 8